# EUROPEAN PATENT APPLICATION

(11) **EP 4 760 453 A1**
(43) Date of publication of application: **17.06.2026**
(21) Application number: 24220354.5
(22) Date of filing: 16.12.2024
(51) Int. Cl.: G06F 1/18, G11B 33/00, H05K 5/00

(54) **SYSTEM FOR MEMORY PRESERVATION**

(71) Applicant: Veoneer Sweden Safety Systems AB, 10302 Stockholm (SE)
(72) Inventor: FOUILLEUL, Antoine, 95800 Cergy-Pontoise (FR); CACLARD, Laurent, 95800 Cergy-Pontoise (FR)
(74) Representative: Reichert & Lindner Partnerschaft Patentanwälte

(57) **Abstract**

A system (1) for memory preservation is disclosed. A liquid tight and gas-tight housing (10) formed by a bottom (11) and a cover (12). A reservoir (14) holds a phase changing material (15). At least one memory device (20) is placed in a liquid-tight enclosure (16) surrounded directly or indirectly by the phase changing material (15).

## Description

The invention relates to a system for memory preservation.

A standard application of a memory device is to save data on at least one memory chip. The memory chip can be part of an electronic circuitry or can be a memory device separate from the electronic circuitry, for example an electronic control unit (ECU) of a vehicle. The memory chip and the electronic circuitry are connected via a bus system. According to the standard application the memory device is protected against high temperature in that the memory device is enclosed in insulated housing.

Because the memory device is low in mass, the thermal inertia is low. Additionally, housing is small, therefore the insulation is not sufficient to delay the rise in temperature. The problem is that there is a limited volume, so little thickness of insulation and a very low mass. Therefore, the low thermal capacity does not help to delay the rise in temperature.

It is an object of the invention to come up with an system that delays the rise of temperature in case a memory device is subjected to an high temperature environment.

The above object is achieved by a system for memory preservation as claimed in claim 1.

The inventive system for memory preservation is defined by a liquid tight housing which is formed by a bottom and a cover. A reservoir, which holds a phase changing material, is placed inside the housing. At least one memory device is placed in a liquid-tight enclosure and surrounded directly or indirectly by the phase changing material inside the.

According to a further embodiment of the invention, a standard insulation can surround the housing with the phase change material. The phase change act as an artificial large thermal capacity, and the insulation is limiting the energy transfer from fire to the thermal capacity. The insulation increases the efficiency of the phase change material inside the housing.

The advantage of the inventive system is that the rise in temperature is delayed.

A phase changing material could be water without alcohol, water with alcohol to achieve an antifreeze property, hydrated salts, paraffins or the like.

One possibility for a phase changing material is water. It takes 4 joules/gram to raise the water one degree and it takes 2000 joules/g to vaporize water. It is clear for a person skilled in the art that besides water other phase changing materials can be used.

One embodiment of the system is that reservoir for the phase changing material is defined by a separate case which fills the housing and is filled with the phase changing material. The case could be made from plastic. The at least one memory device is surrounded by the phase changing material inside the case.

According to a further embodiment, the reservoir is defined by a plurality of balls. The balls fill the housing and each of the balls is filled with the phase changing material. In case that system is subjected, for example to fire, that wall of the balls beaks or melts and sets the phase changing material free. As already mentioned before, the at least one memory device is surrounded inside that housing by the plurality of balls. The advantage with the use of balls is that there is no need for an adjustment of the reservoir to the dimensions of the housing.

An additional embodiment is that the reservoir is defined by a foam element. The foam element fills the housing and is soaked with the phase changing material. The at least one memory device is surrounded by the foam element. The advantage of that embodiment is that the foam element can be easily adapted to the volume provided by the housing and the application of the phase changing material is not complicated and can be easily integrated in a production process.

The liquid-tight housing of the system with the enclosed memory device nan be placed separate from the electronic circuitry (for example ECU). According to a further embodiment the liquid-tight housing with the enclosed memory device can placed as well on the electronic circuitry (for example ECU).

A motor vehicle can be equipped with a system for memory preservation. The inventive system helps to delay the temperature rise close to a memory device in case the motor vehicle is subjected to a fire hazard.

Below, the invention and its advantages will be discussed with reference to the accompanying schematic figures.
**Figure 1** is a schematic representation of the implementation of the invention in a vehicle.
**Figure 2** is an arrangement of a protection of a memory device against high temperature according to the prior art.
**Figure** 3 shows a side view of a closed and liquid-tight housing for a memory device to be protected against high temperature.
**Figure 4** shows an embodiment of the system in a sectional side view of the housing for the memory device.
**Figure 5** shows a further embodiment of the system in a sectional side view of the housing for the memory device.
**Figure 6** shows an additional embodiment of the system in a sectional side view of the housing for the memory device.
**Figure 7** shows a further embodiment of the system, wherein the housing is filled via a pipe with the phase changing material.
**Figure 8** is a diagram showing the temperature as a function of time for a prior art arrangement of the memory and according to an embodiment of the invention.

The figures only show examples of how the invention can be implemented and are not to be taken as a limitation of the invention to the examples shown.

### DETAILED DESCRIPTION

In the ensuing description, numerous specific details are provided to enable maximum understanding of the embodiments that are provided by way of example. The embodiments may be implemented with or without specific details, or else with other methods, components, materials, etc. In other circumstances, well-known structures, materials, or operations are not illustrated or described in detail so that various aspects of the embodiments will not be obscured. In the course of the present description to "an embodiment" or "one embodiment" means that a particular structure, peculiarity, or characteristic described in connection with its implementation is comprised in at least one embodiment.

Same reference numerals refer to same elements or elements of similar function throughout the various figures. Furthermore, only reference numerals necessary for the description of the respective figures are shown in the figures. The embodiments described represent only examples of how the invention can be carried out. This should not be regarded as a limitation of the invention.

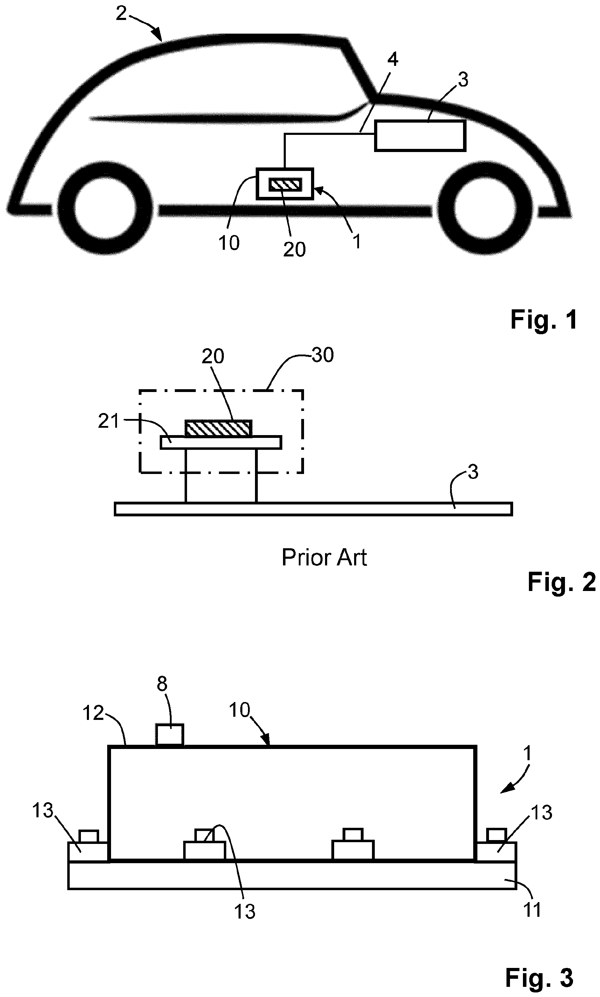

**Figure 1** shows an embodiment of the implementation of the invention in a vehicle 2. The vehicle 2 is a motor vehicle, which should not be regarded as a limitation of the invention. Here, an electronic circuitry 3 is installed at a separate location in or at the vehicle 2 as an inventive system 1, which is defined by a memory device 20 which is enclosed in a liquid-tight and gas-tight housing 10. The electronic circuitry 3 and the liquid-tight housing 1 are connected via a bus 4. The electronic circuitry 3 generates data which are stored in a memory device 20. It is understood by a person skilled in the art that liquid-tight housing 1 can be placed as well on the electronic circuitry 3 (printed circuit board). According to a preferred embodiment of the invention, electronic circuitry 3 is an electronic control unit (ECU) of a vehicle 2.

**Figure 2** shows a prior art arrangement for the protection of the memory device 20 against high temperature. The memory device 20 with its circuit board 21 is placed in closed an insulated housing 30. The circuit board 21 is electrically connected to the electronic circuitry 3. The insulated housing 30 protects the memory device 20 against high temperature. Due to the low mass of the memory device 20 it has a low thermal inertia and because of the small insulated housing 30 the insulation is not good. The prior art device does not provide sufficient protection of the memory device 20 against high temperature, for example in case of a fire.

**Figure 3** shows a side view of a closed and liquid-tight housing 10 which is used to enclose the memory device 20 (see for example Fig, 4) to be protected against high temperature. The liquid-tight and gas-tight housing 10 is defined by a cover 12 and a bottom 11 which are joined together, for example by bolts 13, to achieve the liquid tightness. Cover 12 is provided with a valve 8, which is used for the reduction of excess pressure. The excess pressure is generated by the phase change of the material when the liquid-tight housing is subjected to high temperatures (like in the case of fire).

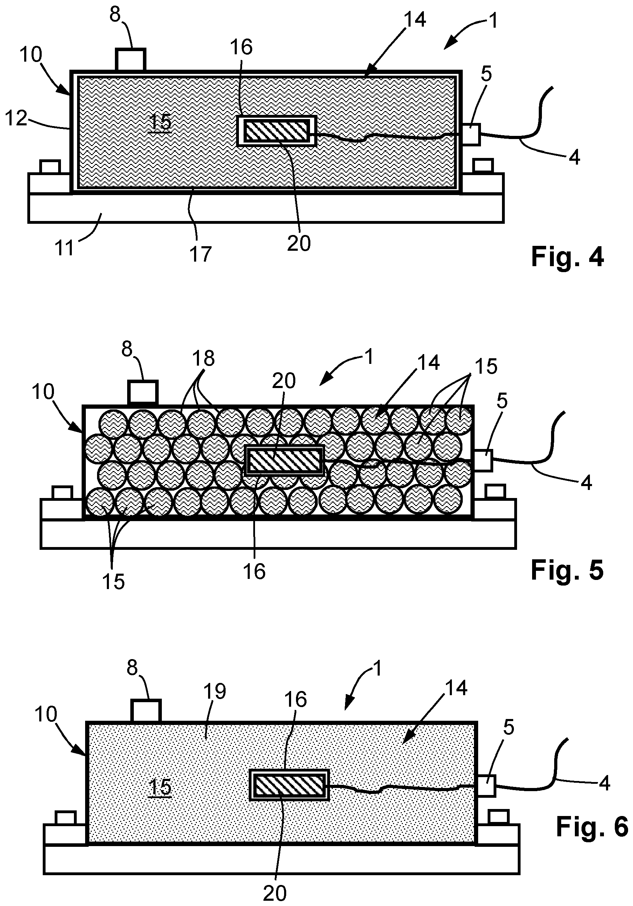

In **Figure 4** an embodiment of the system 1 is shown in a sectional side view. The sectional side discloses the inner structure of the liquid-tight and gas-tight housing 10. The liquid-tight and gas-tight housing 10 encloses a reservoir 14 with the phase changing liquid 15. The reservoir 14 is defined by plastic case 17, which fills the housing 10 and holds the phase changing liquid 15. The memory device 20 with the liquid-tight enclosure 16 is placed inside the plastic case 17 and surrounded completely by phase changing material 15. A bus 4 is connected with the memory device 20, wherein the bus 4 reaches the interior of the liquid-tight and gas-tight housing 10 via a cable bushing 5.

In case of fire (high temperature) the plastic case 17 will break or melt and the phase changing liquid 15 pass into the vapor phase. Excess pressure caused by the vapor phase can escape via valve 8 of the housing 10. In the embodiment as described here the phase changing material 15 is water. As long as phase changing material 15 is present in the housing the temperature within the liquid-tight and gas-tight housing 10 stays at a constant level.

**Figure 5** shows a further embodiment of the system 1 in a sectional side view. Here, the reservoir 14 is defined by a plurality of balls 18 which are filled with the phase changing material 15. The plurality of balls 18 are filled in housing cover 12 and memory device 20 in the liquid-tight enclosure is surrounded by the balls 18.

In case of fire (high temperature) the balls 18 will break and set the phase changing material 15 fee which will pass into the next phase, which is, in the case of water, the vapor phase. As already mentioned in the description of Fig. 4 the excess pressure caused by the vapor phase can escape via valve 8 of the housing 10. According to the embodiment as described here the phase changing material 15 is water.

**Figure 6** shows a further embodiment of the system 1 in a sectional side view. Here, the reservoir 14 is defined by a foam element 19 which fills the housing 10, especially the cover 12 of the housing. The foam element 19 is soaked with the phase changing material 15, which is a liquid in this case, and the memory device 20 in the liquid-tight enclosure 16 surrounded by the foam element 19 soaked with the phase changing material 15.

In case of fire (high temperature) the phase changing material 15 in the foam element 19 will pass into the vapor phase. As already mentioned in the description of Fig. 4 the excess pressure caused by the vapor phase can escape via the valve 8 of the housing 10. According to one possible embodiment, the phase changing material 15 is water.

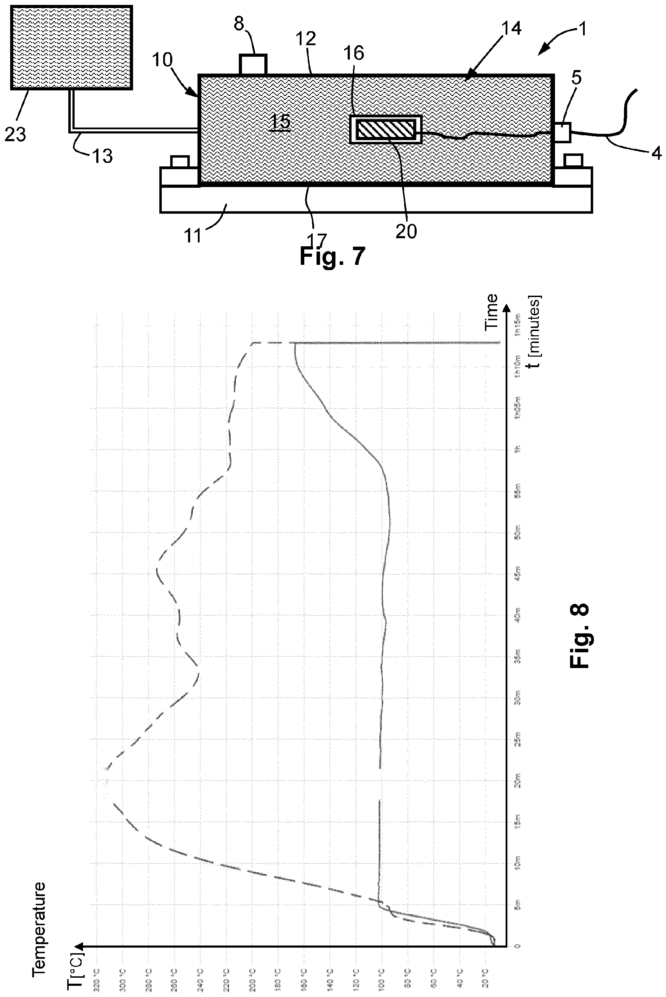

Figure 7 shows a further embodiment of the system 1 in a sectional side view of the liquid-tight housing 10. Here, the embodiment of the liquid-tight housing 10 is filled with the phase changing material 15, which is in this case a phase changing liquid, via a pipe 13. The liquid-tight housing 10 is via pipe 13 in contact with an external reservoir 23. According to one possible example the external reservoir 23 is for example the reservoir for the windshield washer fluid.

**Figure 8** is a diagram showing the temperature as a function of time for a prior art arrangement of the memory device 20 and a memory device 20, which is subjected to high temperature according to an embodiment of the invention. The embodiment used for the test is the embodiment as described in Fig. 6. The dashed line shows the result for an insulated memory device 20 according to prior art. The temperature of the memory device 20 rises 150°C in less than 7 minutes.

The continuous line shows the result for an memory device 20 with the liquid-tight enclosure 15 surrounded by a foam element 19 soaked with water as phase changing material 15. In less than 5 minutes the temperature of memory device 20 rises to 100°C and stabilizes at 100° for about one hour. After one hour all the water is vaporized and temperature increases. This test proves that using a phase changing material, like water, the evaporation phase changing material is an effective way for delaying the temperature rise around the memory device 20.

An additional improvement could be to wrap the memory device 20 and/or the system in an insulation, so that the phase change creates inertia, and the insulation limits the heat to be transmitted to the mass of the housing 10 or the memory device 20.

It is believed that the present disclosure and many of its attendant advantages will be understood by the foregoing description, and it will be apparent that various changes may be made in the form, construction, number and arrangement of the components without departing from the disclosed subject matter or without sacrificing all of its material advantages. The form described is merely explanatory, and it is the intention of the following claims to encompass and include such changes. Accordingly, the scope of the invention should be limited only by the claims appended hereto.

### List of Reference Signs

- 1: System
- 2: Vehicle
- 3: Electronic circuitry
- 4: Bus
- 5: Cable bushing
- 8: Valve
- 10: Liquid-tight housing
- 11: Bottom
- 12: Cover
- 13: Pipe
- 14: Reservoir
- 15: Phase changing material
- 16: Liquid-tight enclosure
- 17: Plastic case
- 18: Ball
- 19: Foam element
- 20: Memory device
- 21: Circuit board
- 23: External reservoir
- 30: Insulated housing

## Claims

1. A system (1) for memory preservation comprising:
a liquid tight housing (10) formed by a bottom (11) and a cover (12);
a reservoir (14) holding a phase changing material (15); and
at least one memory device (20) is placed in a liquid-tight enclosure (16) surrounded directly or indirectly by the phase changing material (15).

2. The system (1) as claimed in claim 1, wherein the reservoir (14) is defined by a plastic case (17) which fills the housing (10) and is filled with the phase changing material (15), wherein the at least one memory device (20) is surrounded by the phase changing material (15).

3. The system (1) as claimed in claim 1, wherein the reservoir (14) is defined by a plurality of balls (18) which fills the housing (10), each of the balls (18) is filled with the phase changing material (15) and the at least one memory device (20) is surrounded by the plurality of balls (18).

4. The system (1) as claimed in claim 1, wherein the reservoir (14) is defined by a foam element (19) which fills the housing (10) and is soaked with the phase changing material (15) is a liquid and the at least one memory device (20) is surrounded by the foam element (19).

5. The system (1) as claimed in any of the preceding claims, wherein the phase changing material (15) is water.

6. The system (1) as claimed in any of the preceding claims, wherein the liquid-tight and gas-tight housing (10) carries a valve (8) to reduce excess pressure and a liquid-tight and gas-tight cable bushing (5) for power supply and data transfer to the memory device (20).

7. The system (1) as claimed in claim 1, wherein the liquid-tight and gas-tight housing (10) with the enclosed memory device (20) is placed separate from the electronic circuitry (3) or the liquid-tight housing and gas-tight (10) with the enclosed memory device (20) is placed on the electronic circuitry (3).

8. The system (1) as claimed in claim 7, wherein electronic circuitry (3) is an electronic circuitry control unit.

9. A motor vehicle (2) with a system (1) for memory preservation according to one of the preceding claims.
